# EUROPEAN PATENT APPLICATION

(11) **EP 2 348 734 A1**
(43) Date of publication of application: **27.07.2011**
(21) Application number: 09824534.3
(22) Date of filing: 16.10.2009
(51) Int. Cl.: H04N 7/32, H03M 7/30, H04N 7/30

(54) **IMAGE ENCODING DEVICE AND IMAGE DECODING DEVICE**

(30) Priority: 07.11.2008 JP 2008286499
(71) Applicant: Mitsubishi Electric Corporation, Tokyo 100-8310 (JP)
(72) Inventor: YAMADA, Yoshihisa, Tokyo 100-8310 (JP); MORIYA, Yoshimi, Tokyo 100-8310 (JP); SEKIGUCHI, Shunichi, Tokyo 100-8310 (JP)
(74) Representative: Pfenning, Meinig & Partner GbR
(86) International application number: PCT/JP2009/005417
(87) International publication number: WO 2010/052833

(57) **Abstract**

An image encoder includes a preprocessing unit 1 for dividing an image signal into two-dimensional blocks of a prescribed size, and for deciding, for each of the blocks divided, the type of a region to which the block belongs, and generates compressed data by executing, for each block divided by the preprocessing unit 1, coding processing corresponding to the type of the region decided by the preprocessing unit 1. This makes it possible to execute coding processing suitable for each region in a picture, thereby being able to implement an image encoder capable of improving coding efficiency.

## Description

### TECHNICAL FIELD

The present invention relates to an image encoder for carrying out variable length coding of an image signal and an image decoder for decoding the image signal undergoing the variable length coding by the image encoder.

### BACKGROUND ART

As a conventional image encoder for carrying out intraframe coding (intra coding), an image encoder employing international standards will be described.
A conventional image encoder transforms a picture from a spatial domain to a frequency domain by dividing the picture into blocks of 8 pixels × 8 lines and by applying a two-dimensional discrete cosine transform (DCT) to each divided block in such a manner as ISO/IEC10918 (commonly known as JPEG: see Non-Patent Document 1) or ISO/IEC14496-2 (commonly known as MPEG-4 visual: see Non-Patent Document 2) does.
Then, predictive processing, which is based on differences between transform coefficients of a coding target block (transform coefficients from the spatial domain to the frequency domain) and transform coefficients of adjacent blocks to the block, is executed to obtain prediction residual transform coefficients.
After that, prescribed quantization processing of the prediction residual transform coefficients is executed to obtain quantization coefficients, followed by variable length coding (Huffman coding) of the quantization coefficients.

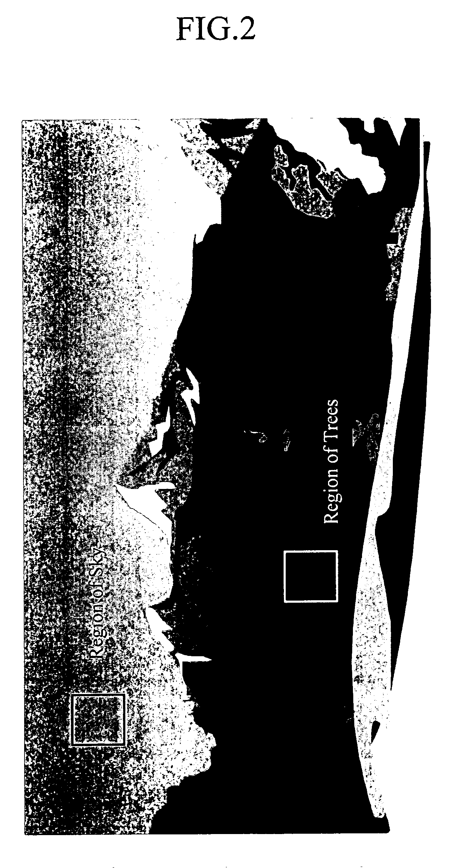

FIG. 2 is a diagram showing an example of a picture.
As shown in FIG. 2, the picture generally includes a variety of subjects.
Accordingly, there are various regions such as a flat region in which an image signal little changes (the background sky, for example), a region in which uniform changes continue (foreground grasslands, for example) and a complex region in which an image signal changes sharply (a region of trees in the center, for example).
At edges on boundaries between the regions, the image signal has very sharp local changes.

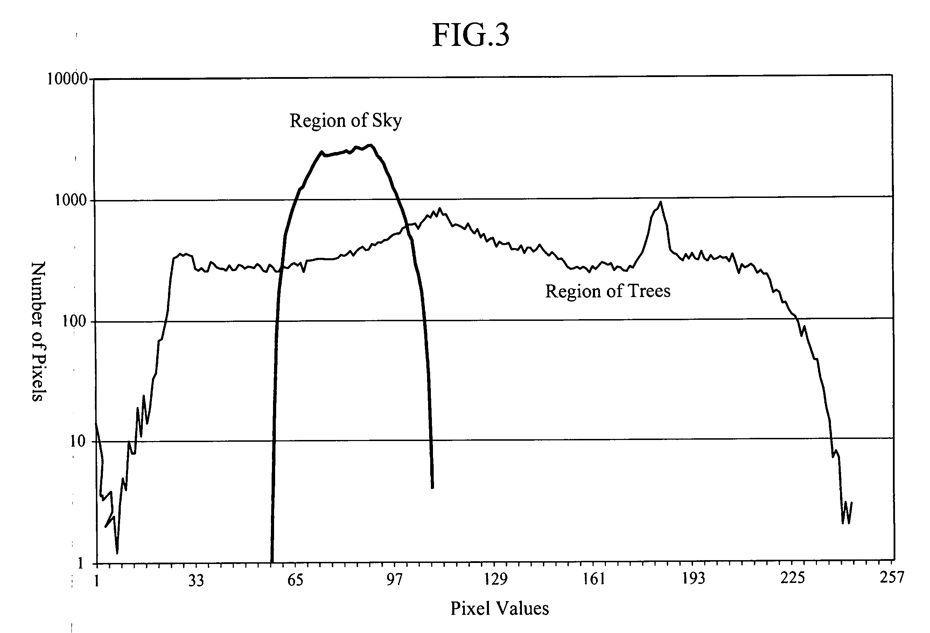

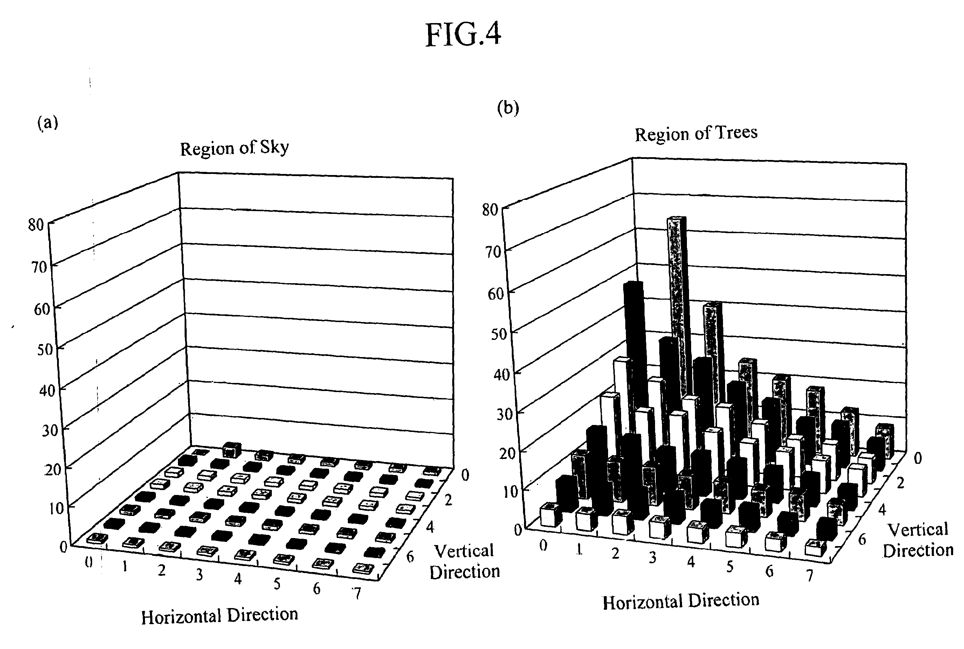

FIG. 3 is a diagram showing characteristics of the image signal in two regions (sky region and tree region) in a picture similar to the picture of FIG. 2.
In the case of an 8-bit image signal, although it has a 256-step gradation of 0 - 255, it is found that the image signal is distributed in a very narrow range of about 60 - 110 in the sky region. In contrast, it is found in the tree region that the image signal is distributed nearly uniformly over the whole steps of 0 - 255.
By performing an 8×8 size two-dimensional DCT on the two regions, followed by measuring electric power of transform coefficients of the two-dimensional DCT, it is found that although almost all the components in the sky region have only weak electric power, many AC (alternating current components) coefficients have considerably large electric power in the tree region.
In particular, it is found in the tree region that large electric power appears in low frequency AC components such as (0, 1) and (1, 0) close to the (0, 0) component which is the DC (direct current) component (to make the figure more legible, the electric power of the direct current component is made zero in FIG. 4. In FIG. 4, although the electric power values taking only positive values are shown, actual transform coefficients assume both the positive and negative values).

### Prior Art Document

### Non-Patent Document

Non-Patent Document 1: ISO/IEC 10918-1 "Information technology--Digital compression and coding of continuous-tone still images--Part 1: Requirements and guidelines".
Non-Patent Document 2: ISO/IEC 14496-2 "Information technology--Coding of audio-visual objects--Part 2: Visual".

### DISCLOSURE OF THE INVENTION

With the foregoing configuration, the conventional image encoder codes the whole image signal in a picture through the same coding processing, although the picture usually includes a region in which the image signal varies greatly and a region in which it little varies. Accordingly, the coding processing suitable for a region in which the image signal little varies will not be appropriate for a region in which the image signal varies greatly, and the processing suitable for a region in which the image signal varies greatly will not be appropriate for a region in which the image signal little varies, which sometimes offers a problem of deteriorating the coding efficiency.

The present invention is implemented to solve the foregoing problem. Therefore it is an object of the present invention to provide an image encoder capable of increasing the coding efficiency by carrying out coding processing suitable for each region in a picture.
In addition, it is an object of the present invention to provide an image decoder capable of decoding the image signal coded by the image encoder.

An image encoder in accordance with the present invention is configured in such a manner that it includes a block dividing unit for dividing an image signal into two-dimensional blocks of a prescribed size; and a region type decision unit for deciding, for each block passing through the division by the block dividing unit, as to which type of a region the block belongs to, and that a coding unit generates compressed data by executing, for each block passing through the division by the block dividing unit, coding processing corresponding to the type of the region decided by the region type decision unit.

According to the present invention, since it is configured in such a manner that it includes the block dividing unit for dividing an image signal into two-dimensional blocks of a prescribed size; and the region type decision unit for deciding, for each block passing through the division by the block dividing unit, as to which type of a region the block belongs to, and that the coding unit generates compressed data by executing, for each block passing through the division by the block dividing unit, coding processing corresponding to the type of the region decided by the region type decision unit, it is able to execute coding processing suitable for each region in a picture, thereby offering an advantage of being able to improve the coding efficiency.

### BRIEF DESCRIPTION OF THE DRAWINGS

FIG. 1 is a block diagram showing a configuration of an image encoder of an embodiment 1 in accordance with the present invention;
FIG. 2 is a view showing an example of a picture;
FIG. 3 is a diagram showing characteristics of image signals in two regions (sky region and tree region) in a picture similar to the picture of FIG. 2;
FIG. 4 is a diagram showing electric powers of individual AC coefficients in the two regions (sky region and tree region) in the picture similar to the picture of FIG. 2;
FIG. 5 is a diagram showing examples of a quantization table;
FIG. 6 is a diagram showing examples of a Huffman code word table;
FIG. 7 is a block diagram showing a configuration of an image encoder of an embodiment 3 in accordance with the present invention;
FIG. 8 is a block diagram showing a configuration of an image decoder of an embodiment 4 in accordance with the present invention;
FIG. 9 is a block diagram showing a configuration of an image decoder of an embodiment 5 in accordance with the present invention;
FIG. 10 is a diagram showing pixels of a coding target block and the like; and
FIG. 11 is a diagram showing pixels of a coding target block and the like.

### BEST MODE FOR CARRYING OUT THE INVENTION

The best mode for carrying out the invention will now be described with reference to the accompanying drawings to explain the present invention in more detail.

### EMBODIMENT 1

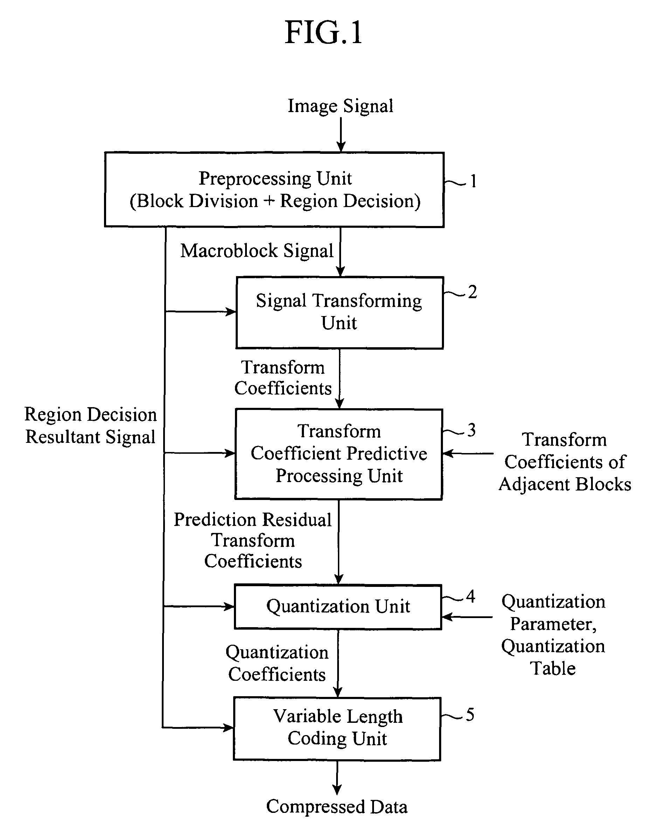

FIG. 1 is a block diagram showing a configuration of an image encoder of an embodiment 1 in accordance with the present invention.
In FIG. 1, when an image signal is input, a preprocessing unit 1 executes processing of dividing the image signal into two-dimensional blocks with a prescribed size (the block will be referred to as "macroblock" from now on according to MPEG) , and of supplying the image signal of each macroblock (referred to as "macroblock signal" from now on) to a signal transforming unit 2.
In addition, the preprocessing unit 1 executes the processing of deciding the type of region to which each macroblock belongs (such as a flat region, edge region and complex region) , and of supplying a region decision resultant signal indicating the type of region to the signal transforming unit 2, a transform coefficient predictive processing unit 3, a quantization unit 4 and a variable length coding unit 5.
Incidentally, the preprocessing unit 1 constitutes a block dividing unit and a region type decision unit.

The signal transforming unit 2, transform coefficient predictive processing unit 3, quantization unit 4 and variable length coding unit 5 constitute a coding unit for executing the coding processing corresponding to the type of region indicated by the region decision resultant signal for each macroblock passing through the division by the preprocessing unit 1 to generate compressed data.
The signal transforming unit 2 is a processing unit (processing unit for executing part of the coding processing) for dividing the spatial domain signal, which is the macroblock signal output from the preprocessing unit 1, into blocks with a prescribed size, for transforming each block to a frequency domain signal, and for outputting transform coefficients thereof. Thus, the block size to be subjected to the transformation processing corresponds to the type of region indicated by the region decision resultant signal output from the preprocessing unit 1, and the signal transforming unit 2 divides the input macroblock signal into blocks with that size, and transforms each block signal after the division from a spatial domain signal to a frequency domain signal.

The transform coefficient predictive processing unit 3 is a processing unit (processing unit for executing part of the coding processing) for generating prediction residual transform coefficients by performing predictive processing between the transform coefficients of the coding target block and the transform coefficients of the blocks adjacent to the coding target block. The transform coefficient predictive processing unit 3 executes the predictive processing by a predictive processing method corresponding to the type of region indicated by the region decision resultant signal output from the preprocessing unit 1.

The quantization unit 4 is a processing unit (processing unit for executing part of the coding processing) for calculating quantization coefficients by performing quantization processing of the prediction residual transform coefficients generated by the transform coefficient predictive processing unit 3. The quantization unit 4 executes the quantization processing using a quantization parameter and a quantization table corresponding to the type of region indicated by the region decision resultant signal output from the preprocessing unit 1.
Here, the "quantization table" is a table that stores weighting values for frequencies and the "quantization parameter" is a weighting value for the quantization table.

The variable length coding unit 5 is a processing unit (processing unit for executing part of the coding processing) for generating compressed data by executing variable length coding processing of the quantization coefficients calculated by the quantization unit 4. The variable length coding unit 5 executes the variable length coding processing using a Huffman code word table (variable-length code word table) corresponding to the type of region indicated by the region decision resultant signal output from the preprocessing unit 1.
In addition, the variable length coding unit 5 codes the region decision resultant signal output from the preprocessing unit 1, includes the coded data of the region decision resultant signal within the compressed data, and supplies them to the image decoder or the like.

Next, the operation will be described.
Receiving the image signal, the preprocessing unit 1 divides the image signal into macroblocks, which are two-dimensional blocks with a prescribed size, and supplies the macroblock signal to the signal transforming unit 2 as the image signal of each macroblock.
In addition, the preprocessing unit 1 decides the type of region to which each macroblock belongs, and supplies the region decision resultant signal indicating the type of region to the signal transforming unit 2, transform coefficient predictive processing unit 3, quantization unit 4 and variable length coding unit 5.
The present embodiment 1 describes the three types as an example: a "flat region" in which the image signal little varies; an "edge region" in which the image signal changes sharply because of a boundary the region includes; and a "complex region" in which the image signal varies greatly.

A decision method of the type of region used by the preprocessing unit 1 will be described concretely below.
The preprocessing unit 1 measures, for example, frequency distribution of the image signal as shown in FIG. 3 on a macroblock-by-macroblock basis.
After measuring the frequency distribution of the image signal on a macroblock-by-macroblock basis, the preprocessing unit 1 sets a narrow range, and decides a region as to which the frequency distribution of the image signal concentrates on the narrow range as a "flat region".
In addition, the preprocessing unit 1 decides a region as to which the frequency distribution of the image signal concentrates on two narrow ranges as an "edge region".
Furthermore, the preprocessing unit 1 decides a region as to which the frequency distribution of the image signal extends over a wide range as a "complex region".

As other decision methods, the following can be conceived.
For example, to obtain the results as shown in FIG. 4, a method can be adduced which transforms the image signal to a frequency domain signal on a block-by-block basis, and classifies it into three regions (flat region, edge region, and complex region) by dividing the total electric power except for the direct current component (DC component) of the transform coefficients into three levels using two thresholds.
As similar techniques, for example, a method is conceivable which measures the electric power of the component at (0, 1) in (horizontal, vertical) directions shown in FIG. 4 and the electric power of the component at (1, 0), and which classifies the sum or average of the electric power of the two components into three levels using two thresholds; or a method which measures the sum and ratio of the electric powers of the components at (0, 1-7) and the electric powers of the components at (1-7, 0), and classifies the measured results into three levels using two thresholds.
When a picture has an edge in a horizontal direction, since the coefficients do not occur at the 1-7 components in the horizontal direction, but large coefficients occur in the 1-7 components in the vertical direction, the presence or absence of the edge can be detected at high accuracy by measuring them in the horizontal direction and vertical direction separately.

Receiving the macroblock signal and the region decision resultant signal from the preprocessing unit 1, the signal transforming unit 2 divides the macroblocks divided by the preprocessing unit 1 in accordance with the size corresponding to the type of region indicated by the region decision resultant signal, and transforms each block signal after the division from the spatial domain signal to the frequency domain signal.
The block size corresponding to the type of region will be described below.

In a "flat region", since a change of the signal within the macroblock is small, and almost all the AC components of the transform coefficients have small values as shown in FIG. 4 (a), even if the block size is enlarged such as "16 × 16", almost all the AC components of the transform coefficients within the block also have small values.
Thus, when a decision of the "flat region" is made, a large block size is selected. In this way, the transformation efficiency is increased at the transformation to the frequency domain.
On the contrary, in the case of a "complex region", since a large block contains a plurality of textures and cannot achieve efficiency of the frequency transformation, reducing the size of a block such as "4×4" can improve the efficiency of the frequency transformation (since the reduction in block size enables processing of a uniform texture, it can increase the efficiency of the frequency transformation).
However, according to a target bit rate or an object of the image coding relating to coded image quality, the coding efficiency can be increased by executing the transformation processing in a different manner. For example, when there is an object of expressing delicate variations in a flat region, it may be better to transform a "flat region" in small blocks, and when it is necessary to carry out compression at a very low bit rate at the cost of the image quality, it may be better to transform a "complex region" in large blocks.

Here, although a case is shown in which the signal transforming unit 2 changes the size for dividing into blocks, it is also possible to switch the transform method of a signal in accordance with the type of region indicated by the region decision resultant signal.
Although the signal transforming unit 2 commonly uses a DCT (discrete cosine transform) as a signal transform method, it can also use a transform method such as wavelet transform, Haar transform, Hadamard transform and slant transform.
These transform methods have their own merits. For example, since the Haar transform and Hadamard transform are constructed from only two transform coefficients of "+1" and "-1", the transform can be achieved by only addition and subtraction. Thus, they have a strong point of being able to achieve transform with a small amount of operation, and to prevent operational error by a processor such as in floating-point operation.
The wavelet transform has a merit of being able to carry out transform without generating a block boundary of a coded image.
The slant transform, which transforms to linearly inclined components such as a V or W, has a merit of being able to carry out transformation with a small number of coefficients for a signal with its brightness or coloring being changed smoothly.

As for a "flat region", it is conceivable to select the wavelet transform that can prevent the occurrence of a block boundary because a block boundary is conspicuous in this region, or to select the Haar transform or Hadamard transform that can prevent the occurrence of the operational error because the operational error is conspicuous in this region.
In addition, as for the "flat region", since the AC components little occur as described before, it is difficult to obtain the difference in the transformation efficiency. Thus, instead of using a transformation such as a DCT with high transformation efficiency but a large amount of operations, a method is conceivable of selecting a Haar transform or Hadamard transform capable of reducing the amount of operations although their transformation efficiency is inferior to the DCT. Alternatively, in the case of a flat region including components with a gradation that uniquely and gently varies, a method is conceivable of selecting slant transform capable of utilizing inclined components.
As for a "complex region", since a block boundary is inconspicuous, a method of selecting a DCT or the like is conceivable. Alternatively, since many transform coefficients of AC components occur, a method of selecting a DCT with higher transformation efficiency can be conceivable.
As for an "edge region", a method can be conceivable of selecting a Haar transform or Hadamard transform that can express a steep edge for edge components in the horizontal or vertical direction. In addition, as for oblique edge components, since many AC components are necessary, a method of selecting a DCT with high transformation efficiency can be conceived.
Alternatively, when a large block size is selected, the number of bits required for the operation increases because of necessity for handling a lot of signals, but when a small block size is selected, only a small amount of signals are handled. Accordingly, when a processor with a limited number of bits used for operations is employed, a method is conceivable of selecting a transformation such as a Haar transform or Hadamard transform that can be achieved with a small amount of operations when a large block size is selected, and selecting a transformation such as a DCT or wavelet transform that requires a large amount of operations when a small block size is selected.

Thus switching the transform method in accordance with a purpose and application of the coding can meet the needs.
This makes it possible to increase the coding compression efficiency and subjective image quality of the decoded image.
Incidentally, although the foregoing explanation is made by way of example that assigns a particular transform method to a decided region in a one-to-one correspondence manner, it is also possible to give priority to the transform methods to be used for each region such as the Hadamard transform, DCT and wavelet transform for a "flat region", and the DCT, wavelet transform and Hadamard transform for the "complex region"; and to add data indicating which transform method is selected to enable selecting the transform method for each region or for each block.
This makes it possible to carry out coding processing using the most appropriate transform method, thereby being able to achieve high coding efficiency.

Receiving the transform coefficients of the coding target macroblock from the signal transforming unit 2, the transform coefficient predictive processing unit 3 executes the predictive processing between the transform coefficients of the coding target block and the transform coefficients of blocks adjacent to the coding target block (referred to as an "adjacent blocks" from now on) to generate prediction residual transform coefficients.
When the transform coefficient predictive processing unit 3 generates the prediction residual transform coefficients by executing the predictive processing, however, it executes the predictive processing using the predictive processing method corresponding to the type of region indicated by the region decision resultant signal output from the preprocessing unit 1.
Next, the predictive processing method corresponding to the type of region will be described.

As for a "flat region", since the transform coefficient values are very small as shown in FIG. 4(a), the predictive processing of the AC coefficients can produce very little effect.
Thus, the transform coefficient predictive processing unit 3 does not perform anypredictive processing of the AC coefficients for a macroblock decided as a flat region.
Although MPEG-4 employs a method of adding for each macroblock a 1-bit flag called "ac_pred_flag", which indicates whether to perform the predictive processing of the AC coefficients or not, to the compressed data without exception, the "ac_pred_flag" can be excluded when the region is decided as a flat region because the AC prediction is not performed in this case.
In this way, 1-bit data can be reduced for one macroblock.

As for an "edge region", large transform coefficients occur in the components (1-7, 0) in (horizontal, vertical) in a block including a horizontal edge, and occur in the components (0, 1-7) in a block including a vertical edge.
When the edge components occur over a plurality of blocks, the adjacent blocks will have nearly the same transform coefficients. Thus, many of the prediction residual transform coefficients become nearly zero when executing the predictive processing of the transform coefficients. Accordingly, it is expected that the coding efficiency will be improved greatly by the post-stage quantization processing and variable length coding processing.
Therefore, the transform coefficient predictive processing unit 3 always executes the predictive processing of the AC coefficients for the macroblock decided as an edge region.
In the case of MPEG-4, this makes it possible to reduce the 1-bit data of the "ac_pred_flag" in the same manner as in the flat region.

As for a "complex region", many transform coefficients occur as shown in FIG. 4(b), and their values become large.
In addition, because of the complex signal, the adjacent blocks do not always have nearly the same transform coefficients.
Therefore, as for the predictive processing of the AC coefficients, it is arranged in such a manner as to enable selection of the processing that can improve the coding efficiency by generating data indicating whether to execute the AC predictive processing or not and by adding the data to the compressed data in the same manner as the "ac_pred_flag" of conventional MPEG-4.

As for the predictive processing of the AC coefficients, a technique of combining it with the post-stage quantization processing of the AC coefficients is conceivable.
In the quantization processing, using a large quantization parameter will cause many AC coefficients to be quantized to zero, thereby producing a large quantization error.
On the other hand, using a small quantization parameter will cause many AC coefficients to be quantized to nonzero, thereby suppressing the quantization error.
Thus, the large quantization parameter has little predictive effect on the AC coefficients. Accordingly, the AC predictive processing is not executed at all. This will make it possible to eliminate the data indicating whether to execute the AC predictive processing or not.
On the other hand, the small quantization parameter will provide either case of having predictive effect on the AC coefficients or not depending on the state of the surrounding image signals. Thus, the data indicating whether to execute the AC predictive processing or not is generated to determine whether to execute the AC prediction or not. This will improve the coding efficiency of the AC predictive processing.

As the predictive processing of the AC coefficients, the conventional MPEG-4 method can be used which simply obtains the differences between the seven AC coefficients of the transform coefficients of the coding target block output from the signal transforming unit 2 and those of the transform coefficients of the adjacent blocks. In addition, a method can also be employed which obtains the differences after executing prescribed weighting processing of halving or doubling the transform coefficients of the adjacent blocks when obtaining the differences, for example.
Alternatively, a method of improving the coding efficiency by switching the number of the target AC coefficients to be subjected to the prediction can also be used by executing the predictive processing on only three AC coefficients close to the DC coefficient or on all the 63 AC coefficients, for example.
In the case of executing the weighting processing or switching the number of the transform coefficients to be predicted, such a parameter indicating the weighting value or the number of the target AC coefficients to be predicted is included in the compressed data output from the variable length coding unit 5 which will be described later.
Alternatively, a method is also conceivable which switches the number of the AC coefficients to be predicted in accordance with the region such as using only the seven horizontal or vertical AC coefficients in the "edge region", but using all the 63 AC coefficients in the "complex region". This will enable the predictive processing suitable for the signal state of each region.
Incidentally, the weighting value can be fixed on a single block or can be varied with the individual components of the 63 AC coefficients. In this case, the 63 weighting values are put in the compressed data.

Receiving the prediction residual transform coefficients from the transform coefficient predictive processing unit 3, the quantization unit 4 executes the quantization processing of the prediction residual transform coefficients using the quantization parameter and quantization table corresponding to the type of region indicated by the region decision resultant signal output from the preprocessing unit 1 and calculates the quantization coefficients.
Normally, the quantization parameter and quantization table used by the quantization unit 4 are set according to the magnitude of a target code amount given to the image encoder or to the magnitude of a code amount that has occurred thereto. The present embodiment 1, however, is configured in such a manner that they are set in accordance with the type of region indicated by the region decision resultant signal output from the preprocessing unit 1.
The quantization parameter and quantization table corresponding to the type of region will be described below.

In a "flat region", since the image signal little changes and almost all the transform coefficients take small values as shown in FIG. 4(a), the prediction residual transform coefficients will take small values as well.
On the contrary, in a "complex region", since the image signal changes greatly and many transform coefficients take large values as shown in FIG. 4 (b), the prediction residual transform coefficients have a tendency to take large values as well.
In an "edgeregion", since particular transform coefficients take large values in accordance with the direction components of the edge, the prediction residual transform coefficients will take small values when the AC prediction is effective, but take large values when the AC prediction is not effective.
Accordingly, when executing high image quality coding processing at a low compression ratio, the quantization parameter is set at a small value in the "flat region" so as to render the image better which exhibits slight changes even though flat.
On the other hand, when executing low image quality coding processing at a high compression ratio, the quantization parameter is set at a large value in the "flat region" so as to make almost all the quantization coefficients zero, thereby increasing the coding efficiency markedly.
In the "complex region", the quantization parameter is made large so as to suppress the occurrence of the code amount.
In the "edge region", a comparatively small quantization parameter is used to suppress coding noise prone to occur around the edge.
In this way, setting the quantization parameter in accordance with the type of region makes it possible to improve the coding efficiency.

As for the quantization table, by setting its values at small or large values, similar effect to that of the quantization parameter can be achieved. In the case of the quantization table, however, it can be set by assigning weights for each frequency domain of the prediction residual transform coefficients.
For example, JPEG or MPEG describes, in the standard reference, recommended values and initial values that set the (0, 1) or (1, 0) component of FIG. 4 at a comparatively small value and (7, 7) component at a comparatively large value.

Although the conventional coding method employs a quantization table having the same value all over the picture, the present embodiment 1 employs the quantization table having different values from region to region.

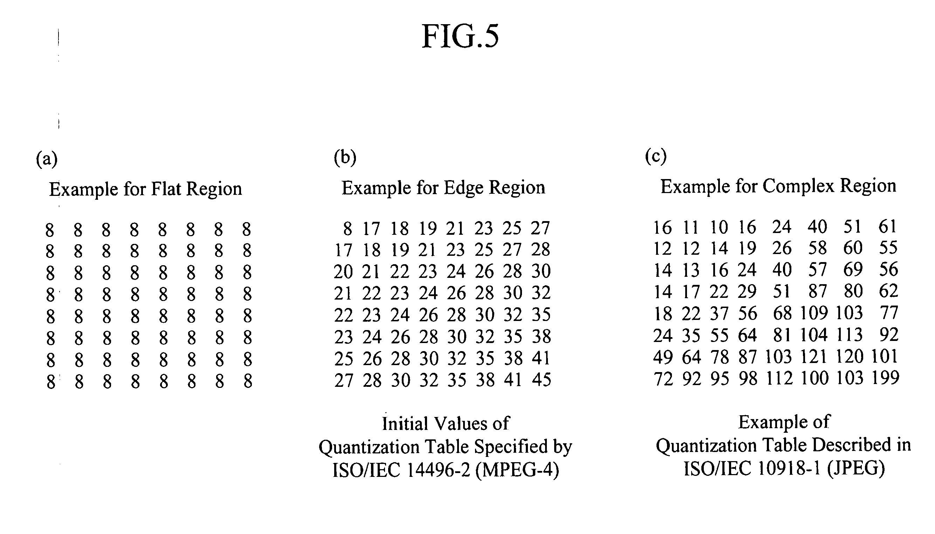

FIG. 5 is a diagram showing an example of the quantization table.
In the "flat region", all the values of the quantization table have a small value as shown in FIG. 5 (a) so as to be able to render an image with minute variation.
In the "complex region", the values of the quantization table are made larger with an increase of the frequency as shown in FIG. 5(c) so that low frequency components can be rendered at a small code amount.
In the "edge region", as in the "complex region", the values of the quantization table are made larger with an increase of the frequency. However, as shown in FIG. 5 (b) , they are set at values smaller than the values of the quantization table in the "complex region".

Incidentally, as for the values of the quantization table, they can be fixed as a standard so that both the image encoder and image decoder set the same values, or the image encoder can transmit to the image decoder the values of the quantization table by putting them in the compressed data so that the values of the quantization table can be update as needed.
Alternatively, it is also possible to prepare a plurality of quantization tables for the individual regions to enable selection of a quantization table, and to code separate data indicating which quantization table is selected. When the compression ratio is high, the code amount can be reduced by using a quantization table with large values. When the compression ratio is low, the image quality can be increased by using a quantization table with small values.

Receiving the quantization coefficients from the quantization unit 4, the variable length coding unit 5 executes variable length coding processing of the quantization coefficients by using a Huffman code word table corresponding to the type of region indicated by the region decision resultant signal output from the preprocessing unit 1, thereby generating the compressed data.
The conventional coding method uses a predetermined Huffman code word table and an arithmetic coding method, and performs the same variable length coding processing for all the regions in a picture. In contrast, the present embodiment 1 switches the Huffman code word table and the arithmetic coding method in accordance with the type of region indicated by the region decision resultant signal output from the preprocessing unit 1, thereby enabling more efficient variable length coding processing.

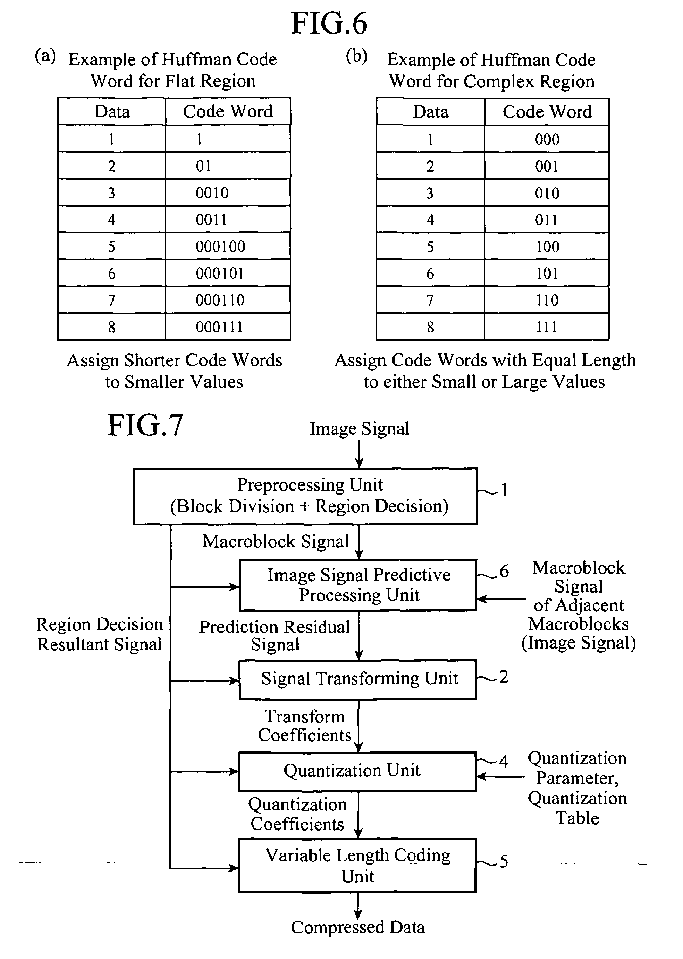

FIG. 6 is a diagram showing examples of the Huffman code word table.
In a "flat region", since the transform coefficient values are small as shown in FIG. 4 (a), many quantization coefficients take a small value.
Accordingly, the Huffman code word table optimized for conditions in which many small values occur as shown in FIG. 6 (a) is used to enable an increase in the efficiency of the variable length coding processing.
In a "complex region", since various transform coefficient values from large to small ones occur as shown in FIG. 4(b), the Huffman code word table optimized for such conditions as shown in FIG. 6 (b) is used to enable an increase in the efficiency of the variable length coding processing.

Although a method in which the variable length coding unit 5 switches the Huffman code word table is shown here, as for the processing called zigzag scanning which rearranges 8×8 two-dimensional block data employed by JPEG or MPEG into 64 one-dimensional data, it is also possible to switch in accordance with the type of region.
For example, in a flat region or complex region, since the transform coefficients reduce uniformly from a low frequency region to a high frequency region as shown in FIG. 4, the conventional zigzag scanning can be used. However, in the case of an edge region, as for a macroblock including a horizontal edge, for example, although the coefficients in a high frequency region in a horizontal direction have only small electric power, the coefficients in a high frequency region in a vertical direction have large electric power. Accordingly, scanning in the vertical direction is carried out preferentially. In contrast, as for a macroblock including an edge in a vertical direction, switching is made to carry out scanning in a horizontal direction preferentially.

Generating the compressed data as described above, the variable length coding unit 5 codes the region decision resultant signal output from the preprocessing unit 1, and transmits to the image decoder the coded data of the region decision resultant signal by including it in the compressed data.

As is clear from the above, according to the present embodiment 1, it is configured in such a manner as to comprise the preprocessing unit 1 which divides the image signal into the two-dimensional blocks with a prescribed size and decides, for each block passing through the division, the type of region to which the block belongs, and to generate the compressed data by executing coding processing corresponding to the type of region decided by the preprocessing unit 1 for each block divided by the preprocessing unit 1. Accordingly, it can execute coding processing appropriate to each region in a picture, thereby offering an advantage of being able to increase the coding efficiency.
Incidentally, although the present embodiment 1 is described on the assumption that all of the signal transforming unit 2, transform coefficient predictive processing unit3, quantization unit 4, and variable length coding unit 5 switch their internal processing in accordance with the type of region decided by the preprocessing unit 1, it is not necessary for all of them to carry out switching. For example, it is also possible for part of them to carry out switching while improving the coding efficiency.

### EMBODIMENT 2

The foregoing embodiment 1 shows an example in which the preprocessing unit 1 decides the type of region and classifies into three types: "flat region", "edge region" and "complex region". The preprocessing unit 1, however, can decide the type of region and classify into two types: "high gradation required region" and "high gradation unrequired region", for example.
A concrete example will be described.

As for a digital image signal, the number of bits of each pixel determines gradation.
For example, an 8-bit pixel can express a 256-step gradation of 0 - 255, and a 12-bit pixel can express a 2048-step gradation of 0 - 2047.
As the number of steps of gradation increases, the expression of the image signal becomes richer, and higher quality becomes achievable. However, an increase in the volume of data causes inconvenience of handling.

In the case of an ordinary image signal, high gradation is not always required over an entire picture, but is necessary only for part of the picture in almost all cases.
It will be described with reference to FIG. 2. As for a tree region, since the image signal changes sharply therein, even if fine signal rendering is achieved, human eyes cannot perceive it. In addition, since coding processing will produce a lot of coding noise, the effect of the high gradation is hardly achieved.
On the other hand, as for a sky region, when it includes delicate shading or gradation in which the sky blue becomes gradually lighter toward the horizon, the image signal little changes. Accordingly, if the number of steps of gradation is small, the power of expression becomes weak. Thus, it sometimes occurs that delicate variations are lost entirely and are expressed in a single color, or the gradation that actually varies little by little changes stepwise so that a natural feeling is lost.

Accordingly, the present embodiment 2 is configured in such a manner that the preprocessing unit 1 distinguish as the type of region between the "high gradation required region" such as a sky region and the "high gradation unrequired region" such as a tree region.
As for the execution of the transformation processing of the macroblock signal in the "high gradation required region", when transforming the macroblock signal output from the preprocessing unit 1 from a spatial domain signal to a frequency domain signal, the signal transforming unit 2 increases the accuracy of the transformation processing by increasing the bit length to be processed, for example, thereby carrying out processing with small errors.
On the other hand, as for the execution of the transformation processing of the macroblock signal in the "high gradation unrequired region", the bit length to be processed is shortened, for example, to lessen the processing load even if the accuracy of the transformation processing is reduced.

When generating the prediction residual transform coefficients by executing the predictive processing, the transform coefficient predictive processing unit 3 executes, when the coding target macroblock is in the "high gradation required region", the predictive processing with small errors by using the transform coefficients of the adjacent macroblocks in the same manner as the foregoing embodiment 1.
On the other hand, when the coding target macroblock is in the "high gradation unrequired region", for example, it shortens the bit length of the processing to reduce the processing load at the cost of the accuracy of the predictive processing.

When executing the quantization processing of the prediction residual transform coefficients output from the transform coefficient predictive processing unit 3, the quantization unit 4 executes, when the coding target macroblock is in the "high gradation required region", the quantization processing with a small quantization error using a quantization parameter with a small value.
Alternatively, it executes the quantization processing with a small quantization error using a quantization table without assigning weights on the frequency domain or a quantization table with small weights.
For example, when using a small value such as 1 - 4 as the quantization parameter at the quantization of the 12-bit prediction residual transform coefficients, the quantization coefficients output from the quantization unit 4 become 12 - 10 bits. However, since many of them have originally small transform coefficient values as shown in FIG. 4 (a), many of the output quantization coefficients have small values, as well.

On the other hand, when the coding target macroblock is in the "high gradation unrequired region", a large quantization error is allowable. Accordingly, the quantization processing is executed by using a quantization parameter with a large value or a quantization table with large weights being assigned on the frequency domain.
For example, when using a large value such as 32 - 128 as the quantization parameter at the quantization of the 12-bit prediction residual transform coefficients, the quantization coefficients output from the quantization unit 4 become 7 - 5 bits, and many quantization coefficients become zero at the same time.

When executing the variable length coding processing of the quantization coefficients output from the quantization unit 4, the variable length coding unit 5 executes, when the coding target macroblock is in the "high gradation required region", the variable length coding processing by using a Huffman code word table (see FIG. 6(a)) optimized for conditions in which a lot of small values occur because many quantization coefficients have small values.
On the other hand, when the coding target macroblock is in the "high gradation unrequired region", many quantization coefficients have a value zero. Accordingly, the variable length coding processing is executed by using a Huffman code word table optimized for conditions in which many zero values occur.

As is clear from the above, according to the present embodiment 2, it is configured in such a manner as to decide the "high gradation required region" and the "high gradation unrequired region", and to execute coding processing corresponding to the decision result. Accordingly, in the same manner as the foregoing embodiment 1, it offers an advantage of being able to increase the coding efficiency.

### EMBODIMENT 3

Although the foregoing embodiment 1 shows an example applied to the coding method of executing the predictive processing of the transform coefficients of MPEG-2 or MPEG-4, it is also applicable to a coding method of executing the predictive processing of the image signal in a spatial domain employed in ISO/IEC 14496-10 (commonly known as AVC (the same method as ITU-T H.264): Non-Patent Document 3), for example.
Non-Patent Document 3: ISO/IEC 14496-10 "Information technology -- Coding of audio-visual objects -- Part 10: Advanced video coding".

FIG. 7 is a block diagram showing a configuration of the image encoder of an embodiment 3 in accordance with the present invention. In FIG. 7, since the same reference numerals designate the same or like components to those of FIG. 1, their description will be omitted.
An image signal predictive processing unit 6 is a processing unit (processing unit for executing part of the coding processing) for generating a prediction residual signal by dividing the macroblock passing through the division by the preprocessing unit 1 into blocks of a prescribed size and by executing the predictive processing between the coding target block signal and an adjacent block signal. The image signal predictive processing unit 6 executes the predictive processing by the predictive processing method corresponding to the type of region indicated by the region decision resultant signal output from the preprocessing unit 1.

Next, the processing contents of the image signal predictive processing unit 6 will be described concretely.
The image signal predictive processing unit 6 generates the prediction signal using the adjacent block signal, and generates the prediction residual signal by executing the predictive processing between the prediction signal and the coding target block signal.
In this case, the closer the prediction signal generated from the adjacent block signal is to the coding target block signal, the closer the prediction residual signal values are to zero. Accordingly, the processing at the post-stage signal transforming unit 2, quantization unit 4 and variable length coding unit 5 can achieve high coding efficiency.

As a generating method of the prediction signal, when making prediction of a luminance signal on a block-by-block basis of 4×4 block and 8×8 block, for example, nine predictive methods are specified in AVC as standards.
In addition, when making prediction on a block-by-block basis of 16×16 block, four predictive methods are specified in AVC as standards.

For example, when the image signal is in a flat region, any predictive processing will achieve nearly equal predictive efficiency. Thus, it is meaningless to prepare a lot of predictive modes.
Accordingly, when the type of region indicated by the region decision resultant signal is a flat region, the predictive modes to be used are limited to only one or 2 - 4 predetermined predictive methods.
Such a restriction can eliminate the code amount for designating the predictive mode.
For example, consider a case of specifying the predictive mode by a fixed-bit length. When using nine predictive methods, a 4-bit code length is required to distinguish nine predictive methods. In contrast, when the predictive mode is only one, a code for specifying the predictive mode is not necessary, and when it is limited to four predictive methods, a 2-bit code length is enough for specifying the four predictive methods.

In addition, as for the flat region, even if the predictive processing is performed on each of the 16 4×4 blocks or on one 16×16 block, only nearly the same predictive efficiency can be achieved.
Accordingly, as for the flat region, prediction is performed only on a 16×16 block-by-block basis, thereby eliminating mode information indicating what block size is used as a unit for carrying out predictive processing.

When the image signal is in a complex region, any predictive processing will achieve no big difference except when the image signal has a strong feature such as an edge. However, since a 4×4 block can follow local changes in the image signal more easily than an 8×8 block or 16×16 block, it can increase coding performance in general.
Accordingly, as for the complex region, only prediction is carries out on a 4×4 block-by-block basis to eliminate the mode information indicating what block size is used as a unit for executing the predictive processing.

### EMBODIMENT 4

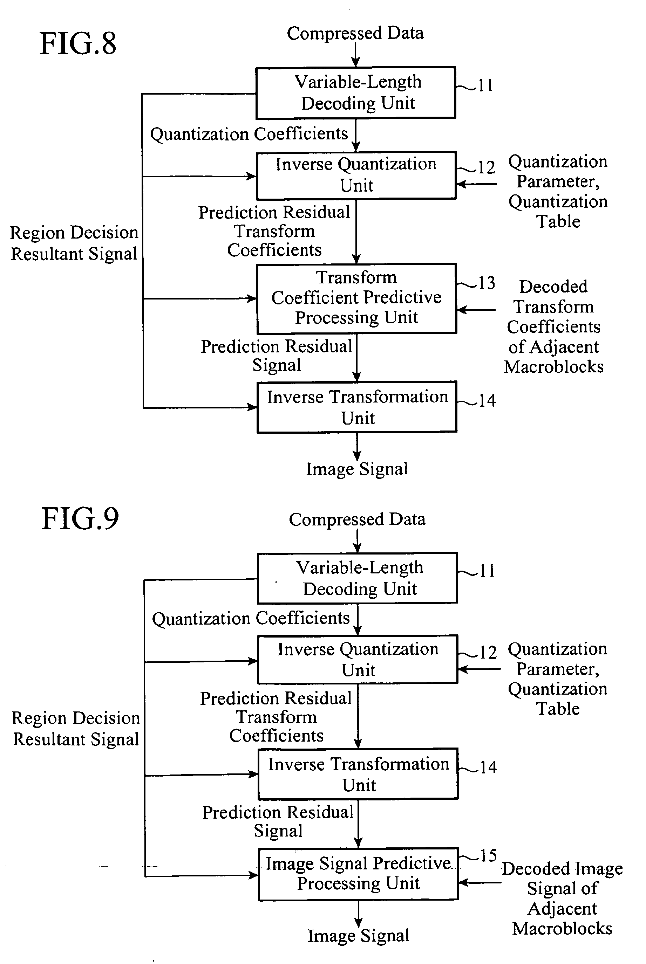

FIG. 8 is a block diagram showing a configuration of the image decoder of an embodiment 4 in accordance with the present invention.
The image decoder of FIG. 8 corresponds to the image encoder of FIG. 1 and employs a decoding method of executing the predictive processing on the transform coefficients of MPEG-2 or MPEG-4.
In FIG. 8, a variable-length decoding unit 11, receiving the compressed data transmitted from the image encoder, executes the variable-length decoding processing (such as Huffman decoding or arithmetic decoding) of the compressed data, thereby executing the processing of decoding the region decision resultant signal and the quantization coefficients included in the compressed data.
Here, when the variable-length decoding unit 11 decodes the quantization coefficients, it executes the variable-length decoding processing using a Huffman code word table (variable-length code word table) corresponding to the type of region indicated by the region decision resultant signal decoded previously.
Incidentally, the variable-length decoding unit 11 constitutes a region decision resultant signal extracting unit.

The variable-length decoding unit 11, inverse quantization unit 12, transform coefficient predictive processing unit 13 and inverse transformation unit 14 constitute a decoding unit for decoding the image signal from the compressed data of two-dimensional blocks passing through the division into the prescribed size by executing the decoding processing corresponding to the type of region indicated by the region decision resultant signal.
The inverse quantization unit 12 is a processing unit (processing unit for executing part of the decoding processing) for decoding the prediction residual transform coefficients by executing inverse quantization of the quantization coefficients decoded by the variable-length decoding unit 11. The inverse quantization unit 12 executes the inverse quantization using a quantization parameter and a quantization table corresponding to the type of region indicated by the region decision resultant signal decoded by the variable-length decoding unit 11.

The transform coefficient predictive processing unit 13 is a processing unit (processing unit for executing part of the decoding processing) for decoding the prediction residual signal by generating the predictive transform coefficients using decoded transform coefficients of the adjacent blocks and by executing the predictive processing between the predictive transform coefficients and the prediction residual transform coefficients of the block decoded by the inverse quantization unit 12. The transform coefficient predictive processing unit 13 executes the predictive processing by the predictive processing method corresponding to the type of region indicated by the region decision resultant signal decoded by the variable-length decoding unit 11.

The inverse transformation unit 14 is a processing unit (processing unit for executing part of the decoding processing) for transforming the frequency domain signal, which is the prediction residual signal decoded by the transform coefficient predictive processing unit 13, to a spatial domain signal. The inverse transformation unit 14 transforms the prediction residual signal from the frequency domain signal to the spatial domain signal using as the unit block size the size corresponding to the type of region indicated by the region decision resultant signal decoded by the variable-length decoding unit 11.

Next, the operation will be described.
Receiving the compressed data transmitted from the image encoder, the variable-length decoding unit 11 decodes the region decision resultant signal included in the compressed data by executing the variable-length decoding processingsuch asHuffman decoding or arithmetic decoding, and supplies the region decision resultant signal to the inverse quantization unit 12, transform coefficient predictive processing unit 13 and inverse transformation unit 14.
In addition, the variable-length decoding unit 11 decodes the quantization coefficients (coefficients corresponding to the quantization coefficients output from the quantization unit 4 of FIG. 1) contained in the compressed data by executing the variable-length decoding processing of the compressed data using a Huffman code word table corresponding to the type of region indicated by the region decision resultant signal decoded previously.
Incidentally, as for the Huffman code word table corresponding to the type of region, since it is the same as that of the foregoing embodiment 1, the description thereof will be omitted.

Receiving the quantization coefficients from the variable-length decoding unit 11, the inverse quantization unit 12 decodes the prediction residual transform coefficients (coefficients corresponding to the prediction residual transform coefficients output from the transform coefficient predictive processing unit 3 of FIG. 1) by executing the inverse quantization of the quantization coefficients using the quantization parameter and quantization table corresponding to the type of region indicated by the region decision resultant signal output from the variable-length decoding unit 11.
Incidentally, as for the quantization parameter and quantization table corresponding to the type of region, since they are the same as those of the foregoing embodiment 1, their description will be omitted.

Receiving the prediction residual transform coefficients from the inverse quantization unit 12, the transform coefficient predictive processing unit 13 generates the predictive transform coefficients using the decoded transform coefficients of the adjacent blocks. As a method of generating the predictive transform coefficients, the same method as the transform coefficient predictive processing unit 3 of FIG. 1 employs for generating the prediction signal is used.
After generating the prediction signal, the transform coefficient predictive processing unit 13 decodes the prediction residual signal (signal corresponding to the frequency domain signal passing through the transformation by the signal transforming unit 2 of FIG. 1) by executing the predictive processing by a predictive processing method corresponding to the type of region indicated by the region decision resultant signal output from the variable-length decoding unit 11 between the predictive transform coefficients and the prediction residual transform coefficients decoded by the inverse quantization unit 12.
Incidentally, as for the predictive processing method corresponding to the type of region, since it is the same as that of the foregoing embodiment 1, the description thereof will be omitted.

Receiving the prediction residual signal of the block from the transform coefficient predictive processing unit 13, the inverse transformation unit 14 transforms the prediction residual signal from the frequency domain signal to the spatial domain signal (image signal) using as a unit the block size corresponding to the type of region indicated by the region decision resultant signal output from the variable-length decoding unit 11.
Incidentally, as for the block size corresponding to the type of region, since it is the same as that of the foregoing embodiment 1, the description thereof will be omitted.

As is clear from the above, according to the present embodiment 4, it is configured in such a manner as to extract the region decision resultant signal indicating the type of region to which the macroblock belongs from the compressed data of the two-dimensional macroblock divided into a prescribed size, and to decode the image signal from the compressed data of the two-dimensional macroblock by executing the decoding processing corresponding to the type of region indicated by the region decision resultant signal. Accordingly, it offers an advantage of being able to decode the image signal coded by the image encoder of FIG. 1. Incidentally, although the embodiment 4 is described on the assumption that all the inverse quantization unit 12, transform coefficient predictive processing unit 13, and inverse transformation unit 14 switch their internal processing in response to the region decision resultant signal decoded by the variable-length decoding unit 11, it is not necessary to switch all of them. For example, when the compressed data as to which only part of the processing is switched by the image encoder is input, a configuration is also possible which switches only corresponding part of the processing.

### EMBODIMENT 5

FIG. 9 is a block diagram showing a configuration of the image decoder of an embodiment 5 in accordance with the present invention. In FIG. 9, since the same reference numerals designate the same or like components to those of FIG. 8, their description will be omitted.
The image decoder of FIG. 9 corresponds to the image encoder of FIG. 7 and employs a decoding method of executing the predictive processing on a spatial domain such as AVC.
In FIG. 9, an image signal predictive processing unit 15, which corresponds to the image signal predictive processing unit 6 of FIG. 7, is a processing unit (processing unit for executing part of the decoding processing) for decoding the image signal by executing the predictive processing between the prediction residual signal of a decoding target block (spatial domain signal passing through the inverse transformation by the inverse transformation unit 14) and the decoded image signal of the adjacent blocks. The image signal predictive processing unit 15 executes the predictive processing by the predictive processing method corresponding to the type of region indicated by the region decision resultant signal output from the variable-length decoding unit 11.

Next, the operation will be described.
Receiving the prediction residual signal of the decoding target block, which is the spatial domain signal from the inverse transformation unit 14, the image signal predictive processing unit 15 generates the prediction signal from the decoded image signal of the adjacent blocks by the same method as that of the image signal predictive processing unit 6 of FIG. 7.
Then, the image signal predictive processing unit 15 decodes the image signal by executing the predictive processing between the prediction signal and the prediction residual signal of the decoding target block by the predictive processing method corresponding to the type of region indicated by the region decision resultant signal output from the variable-length decoding unit 11.
According to the present embodiment 5, it can decode the image signal coded by the image encoder of FIG. 7.
Incidentally, the foregoing embodiment 4 and the embodiment 5 are described on the assumption that the inverse quantization unit, coefficient transform predictive processing unit and inverse transformation unit switch their operation in response to the values of the region decision resultant signal. However, when using the data indicating which transform method is selected for each block as described in the foregoing embodiment 1 (see paragraph [0023]), they are configured in such a manner as to perform combined processing using the transform method corresponding to that data. When they have a plurality of quantization tables and use the data indicating which quantization table is selected (see paragraph [0034]), they are constructed in such a manner as to perform the decoding processing using the quantization table corresponding to that data.

### EMBODIMENT 6

The present embodiment 6 will be described by way of example that executes the predictive processing by the predictive processing method corresponding to the type of region indicated by the region decision resultant signal output from the preprocessing unit 1 when the image signal predictive processing unit 6 of FIG. 7, for example, generates the prediction residual signal by executing the predictive processing between the macroblock signal (image signal of the coding target block) output from the preprocessing unit 1 and the macroblock signal of the adjacent macroblocks.

Although the foregoing embodiment 3 describes the technique of switching the block size using the predictive processing method of the image signal used in the AVC, it is also possible to switch the predictive processing method of the image signal in accordance with the type of region decided by the preprocessing unit 1.
Next, a predictive processing method suitable for the "flat region" will be described.

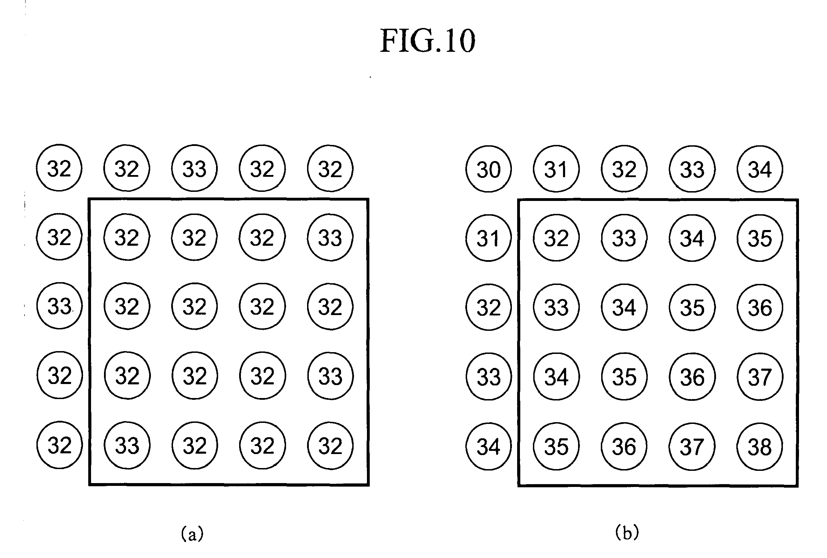

FIG. 10 is a diagram showing pixels of a coding target block.
Pixels inside a square are pixels of coding target block. In the example of FIG. 10, the coding target block is a block with a 4×4 size. In addition, pixels outside the square are pixels used for the predictive processing.
Numerals designate pixel values and the example of FIG. 10 supposes a "flat region".

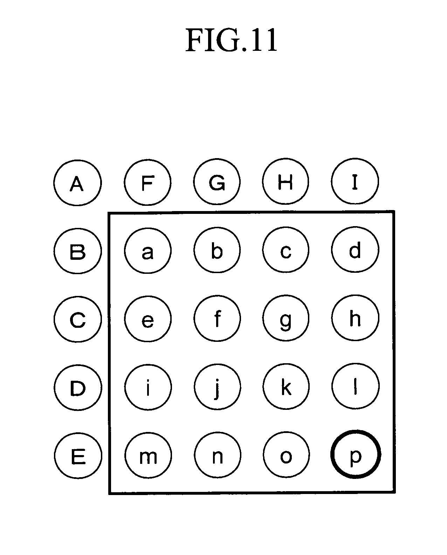

When the signal belongs to a "flat region", the signal inside the block is nearly constant as shown in FIG. 10(a). Alternatively, as shown in FIG. 10(b), the signal inside the block is supposed to vary gently in a particular direction. The predictive processing of the AVC carries out extrapolation by using A - I pixels on the perimeter of the coding target block as shown in FIG. 11. Accordingly, although high predictive efficiency is obtained as to the signal shown in FIG. 10 (a) , as for the signal shown in FIG. 10(b), enough predictive efficiency cannot be obtained for the pixels distant from the A - I pixels like the pixels h, k, n, l, o and p.

Accordingly, the predictive effect is imp roved by generating the predictive image by including the value of the pixel p of FIG. 11 into the coded data and by executing interpolation using the value of pixel p.
As a coding method of the value of pixel p, coding the value of pixel p itself (in the case of FIG. 10(b), coding the value "38") is appropriate. In this case, it is not necessary to perform an extra operation to obtain the value of pixel p.
Alternatively, as a coding method of the value of pixel p, it is possible to obtain an average value of the two pixels E and I closest to the pixel p among the A - I pixels on the perimeter of the coding target block, and to code the difference value between the average value and the value of pixel p (in the case of FIG. 10(b), the average value becomes "34" and the difference value becomes "+4"). In such a case, if a flat region is supposed, since the difference value becomes nearly zero, it is possible to make the coding efficiency higher than when coding the value of pixel p itself.
Furthermore, as a coding method of the value of pixel p, it is also possible to obtain the average value of all the pixels A - I on the perimeter of the coding target block, and to code the difference value between the average value and the value of pixel p (in the case of FIG. 10(b), the average value is "32.22", and the difference value is "+5.78"). In this case, even if the pixels on the perimeter of the coding target include noise, since the average value is obtained using many pixels, the effect of the noise can be weakened.

Any one of the three types of the coding method can be used or they can be switched in accordance with the size of the coding block.
For example, when the block size is 16×16, since the pixel p at the lower right within the block is distant from the pixels on the perimeter, the value of the pixel p itself is used. On the other hand, when the block size is 4×4, since the pixel p is close to the pixels on the perimeter, a technique is conceivable which obtains the average value of the pixels E and I, and uses the difference value between the average value and the value of the pixel p.

Then, the predictive image is generated by the interpolation using the pixel p and the pixels A - I on the perimeter obtained as described above.
As a calculation method of interpolation, conventionally known interpolation is employed such as linear interpolation of assigning weights in accordance with the distance using two pixels (for example, obtaining the predictive value of pixel m by (3×E+p)/4), or bilinear interpolation of assigning weights in accordance with the distance using four pixels (for example, obtaining the predictive value of pixel k by (A + 2×E + 2×I + 3×p)/8).
Incidentally, as for the coded data representing the value of the pixel p (the value of the pixel p itself or the difference value from the average value of the pixels on the perimeter), it is possible to carry out not only coding the value itself, but also coding after executing quantization such as using only the upper 6 bits of the value. Since the quantization narrows the range of the value, it can reduce the code amount of the coded data.

The present embodiment 6 is configured in such a manner as to switch the predictive processing method inclusive of such an interpolation predictive technique in accordance with the type of region decided.
In this way, it can execute its coding processing by switching between various predictive processing methods such as: the extrapolation prediction in the spatial domain when the signal is nearly uniform within the block and is decided as a "flat region" as in the case of FIG. 10 (a) ; the interpolation prediction in the spatial domain when the signal within the block gently varies toward a particular direction as in the case of FIG. 10 (b) ; the DC/AC coefficient predictive processing for the transform coefficients for an "edge region"; and the DC coefficient predictive processing for the transform coefficients for a "complex region".

More specifically, in the case of a uniform "flat region", even though the interpolation prediction is executed, it does not make any difference in the efficiency of the prediction. Accordingly, the extrapolation prediction is selected which does not require coding of the pixel p. In the case of a "flat region" that changes gently, the interpolation prediction is employed to obtain high predictive efficiency as described above.
As for the "edge region", in the case of the horizontal edge or vertical edge in particular, since the predictive efficiency of the AC coefficients is high, the predictive processing of the DC coefficients and AC coefficients is performed on the transform coefficients to obtain the high coding efficiency without executing the interpolation or extrapolation processing in the spatial domain.
As for the "complex region", since predictive efficiency cannot be obtained so much, only the predictive processing of the DC coefficients is executed to reduce unnecessary operation processing.

Since the foregoing examples decide the predictive processing method uniquely in accordance with the type of region decided, they do not require information about the predictive processing method. However, it is also possible to select the predictive processing method capable of achieving the highest predictive efficiency by executing various types of the predictive processing methods.
In this case, although selection information on which predictive processing method is to be selected is necessary, the code amount of the selection information about the predictive processing method can be reduced by giving priority to the predictive processing method for each region selected.
For example, it can code the selection information with a smaller code amount for a predictive processing method to be selected more often by assigning priority in advance in accordance with the order of easily selected predictive processing methods such as in order of the interpolation prediction, extrapolation prediction, DC prediction and DC/AC coefficient prediction in the case of the uniform "flat region", in order of the extrapolation prediction, interpolation prediction, DC prediction, and DC/AC coefficient prediction in the case of the "flat region" that gently varies, and in order of no prediction, the DC prediction, and interpolation prediction in the case of the "complex region" .

Next, the image signal predictive processing of the image decoder for executing the decoding processing of the coded data processed by the foregoing embodiment will be described.
For example, the image signal predictive processing unit 15 of FIG. 9 executes the image signal predictive processing by using the predictive processing method corresponding to the type of region indicated by the region decision resultant signal output from the variable-length decoding unit 11.
Concretely, as for the image decoder corresponding to the image encoder that decides the predictive processing method uniquely in accordance with the decided region, the image signal predictive processing unit 15 executes the predictive processing in the predictive processing method corresponding to the type of region indicated by the region decision resultant signal output from the variable-length decoding unit 11.
More specifically, the image signal predictive processing unit 15 predicts the image signal by the extrapolation prediction if the type of region is a uniform "flat region", predicts the image signal by the interpolation prediction if the type of region is a "flat region" that varies gently, and predicts the image signal by the DC/AC coefficient prediction processing if the type of region is an "edge region". In addition, if the type of region is a "complex region", it predicts the image signal by the DC coefficient predictive processing.

On the other hand, as for the image decoder corresponding to the image encoder that codes the selection information about the predictive processing method, the variable-length decoding unit 11 decodes the coded selection information about the predictive processing method, and the image signal predictive processing unit 15 identifies the predictive processing method from the selection information decoded by the variable-length decoding unit 11, and predicts the image signal by the predictive processing method.

Although the foregoing embodiments 1 - 6 show examples of carrying out variable length coding of the image signal, when the image signal is a color image signal, it is composed of three or more components such as red/blue/green or a combination of a luminance signal and two color difference signals.
Differences in the signal components are known such as that although the luminance signal or green component includes a lot of high frequency components, the two color difference signals or red/blue components little includes the high frequency components.
When coding such color image signals, the Non-Patent Documents 1 - 3 disclose techniques of collecting a plurality of signal components belonging to the same spatial positions into a single macroblock to be coded so as to enable coding processing of all the signals of the components belonging to a particular macroblock as the signals belonging to a single region. However, it is also possible to employ a method of obtaining the region decision resultant signals by the number of signal components by executing the region type decision processing for each component, and to switch the processing of the signal transformation/quantization/variable length coding processing using the region decision resultant signal for each component.
In this case, higher coding efficiency can be achieved because the coding processing becomes possible which makes use of the differences in the individual signal components.

### INDUSTRIAL APPLICABILITY

The present invention is suitable for an image encoder that must increase the coding efficiency by executing the coding processing appropriate to each region within the picture.

## Claims

1. An image encoder comprising:
a block dividing unit for dividing an image signal into two-dimensional blocks of a prescribed size;
a region type decision unit for deciding, for each block passing through the division by the block dividing unit, as to which type of a region the block belongs to; and
a coding unit for generating compressed data by executing, for each block passing through the division by the block dividing unit, coding processing corresponding to the type of the region decided by the region type decision unit.

2. The image encoder according to claim 1, wherein
the coding unit comprises, as a processing unit for executing part of the coding processing, a signal transforming unit for transforming a spatial domain signal which is a signal of the block passing through the division by the block dividing unit into a frequency domain signal and for outputting its transform coefficients, and wherein
the signal transforming unit changes the size of the block to a size corresponding to the type of the region decided by the region type decision unit, and transforms the signal of the block undergoing the size change from a spatial domain signal to a frequency domain signal.

3. The image encoder according to claim 1, wherein
the coding unit comprises, as a processing unit for executing part of the coding processing, a predictive processing unit for generating prediction residual transform coefficients by executing predictive processing between transform coefficients of a coding target block and transform coefficients of blocks adjacent to the block among the blocks passing through the division by the block dividing unit, and wherein
the predictive processing unit executes the predictive processing by a predictive processing method corresponding to the type of the region decided by the region type decision unit.

4. The image encoder according to claim 1, wherein
the coding unit comprises, as a processing unit for executing part of the coding processing, a quantization unit for calculating quantization coefficients by executing quantization processing of prediction residual transform coefficients of the block passing through the division by the block dividing unit, and wherein
the quantization unit executes the quantization processing using a quantization parameter and a quantization table corresponding to the type of the region decided by the region type decision unit.

5. The image encoder according to claim 1, wherein
the coding unit comprises, as a processing unit for executing part of the coding processing, a variable length coding unit for generating compressed data by executing variable length coding processing on quantization coefficients of the block passing through the division by the block dividing unit, and wherein
the variable length coding unit executes variable length coding processing using a variable-length code word table corresponding to the type of the region decided by the region type decision unit.

6. The image encoder according to claim 1, wherein
the coding unit codes the region decision resultant signal indicating the type of the region decided by the region type decision unit, and includes coded data of the region decision resultant signal in the compressed data.

7. The image encoder according to claim 1, wherein
the coding unit comprises, as a processing unit for executing part of the coding processing, a predictive processing unit for generating a prediction residual signal by executing predictive processing between an image signal of a coding target block and an image signal of blocks adjacent to the block among the blocks passing through the division by the block dividing unit, and wherein
the predictive processing unit executes the predictive processing by a predictive processing method corresponding to the type of the region decided by the region type decision unit.

8. An image decoder comprising:
a region decision resultant signal extracting unit for extracting, from compressed data of a two-dimensional block divided into a prescribed size, a region decision resultant signal indicating a type of a region to which the block belongs; and
a decoding unit for decoding an image signal from the compressed data of the two-dimensional block by executing decoding processing corresponding to the type of the region indicated by the region decision resultant signal extracted by the region decision resultant signal extracting unit.

9. The image decoder according to claim 8, wherein
the decoding unit comprises, as a processing unit for executing part of the decoding processing, a variable-length decoding unit for decoding quantization coefficients by executing variable-length decoding processing of the compressed data of the two-dimensional block, and wherein
the variable-length decoding unit executes the variable-length decoding processing using a variable-length code word table corresponding to the type of the region indicated by the region decision resultant signal extracted by the region decision resultant signal extracting unit.

10. The image decoder according to claim 8, wherein
the decoding unit comprises, as a processing unit for executing part of the decoding processing, an inverse quantization unit for decoding prediction residual transform coefficients by executing inverse quantization processing of quantization coefficients of the two-dimensional block, and wherein
the inverse quantization unit executes the inverse quantization processing using a quantization parameter and a quantization table corresponding to the type of the region indicated by the region decision resultant signal extracted by the region decision resultant signal extracting unit.

11. The image decoder according to claim 8, wherein
the decoding unit comprises, as a processing unit for executing part of the decoding processing, a predictive processing unit for decoding a prediction residual signal by executing predictive processing between prediction residual transform coefficients of a decoding target block and prediction residual transform coefficients of blocks adjacent to the block among two-dimensional blocks divided into a prescribed size, and wherein
the predictive processing unit executes the predictive processing by a predictive processing method corresponding to the type of the region indicated by the region decision resultant signal extracted by the region decision resultant signal extracting unit.

12. The image decoder according to claim 8, wherein
the decoding unit comprises, as a processing unit for executing part of the decoding processing, an inverse transformation unit for transforming a frequency domain signal, which is a prediction residual signal of the two-dimensional block, to a spatial domain signal, and wherein
the inverse transformation unit changes the size of the two-dimensional block to a size corresponding to the type of the region indicated by the region decision resultant signal extracted by the region decision resultant signal extracting unit, and transforms the prediction residual signal of the two-dimensional block undergoing the size change from a frequency domain signal to a spatial domain signal.

13. The image decoder according to claim 8, wherein
the decoding unit comprises, as a processing unit for executing part of the decoding processing, a predictive processing unit for decoding the image signal by executing predictive processing between a prediction residual signal of a decoding target block and a prediction residual signal of blocks adjacent the block among the two-dimensional blocks divided into the prescribed size, and wherein
the predictive processing unit executes the predictive processing by a predictive processing method corresponding to the type of the region indicated by the region decision resultant signal extracted by the region decision resultant signal extracting unit.

14. The image decoder according to claim 8, wherein
the decoding unit comprises, as a processing unit for executing part of the decoding processing, a predictive processing unit for decoding the image signal by executing predictive processing between a prediction residual signal of a decoding target block and a prediction residual signal of blocks adjacent to the block among the two-dimensional blocks divided into the prescribed size, and wherein
the predictive processing unit identifies a predictive processing method from selection information transmitted from an image encoder, and executes the predictive processing by the predictive processing method.
